# EUROPEAN PATENT SPECIFICATION

(11) **EP 4 596 932 B1**
(45) Date of publication and mention of the grant of the patent: **18.03.2026**
(21) Application number: 25154362.5
(22) Date of filing: 28.01.2025
(51) Int. Cl.: F16K 11/02, B01F 23/213, C23C 16/455, F16K 11/00, B01D 3/34, B01F 23/10, C23C 16/448

(54) **GAS-LIQUID MIXER AND LIQUID MATERIAL VAPORIZER**
GAS-FLÜSSIGKEITS-MISCHER UND FLÜSSIGMATERIALVERDAMPFER
MÉLANGEUR GAZ-LIQUIDE ET VAPORISATEUR DE MATÉRIAU LIQUIDE

(30) Priority: 01.02.2024 JP 2024014132
(43) Date of publication of application: 06.08.2025
(73) Proprietor: Horiba Stec, Co., Ltd., Kyoto-shi, Kyoto 601-8116 (JP)
(72) Inventor: HIRAI, Soichiro, Kyoto-shi, Kyoto, 601-8116 (JP); NISHIWAKI, Keisuke, Kyoto-shi, Kyoto, 601-8116 (JP)
(74) Representative: Müller-Boré & Partner Patentanwälte PartG mbB

(56) References cited:
- WO-A1-2021/044721
- JP-B2- 4 393 677

## Description

### BACKGROUND OF THE INVENTION

### 1. TECHNICAL FIELD

The present invention relates to a gas-liquid mixer and a liquid material vaporizer.

### 2. DESCRIPTION OF THE RELATED ART

As is shown in Patent Document 1, a device that is provided with a main body block having a mixing portion that mixes a liquid material with a carrier gas, and with a control valve that is provided in the main body block and adjusts a flow rate of the liquid material may be considered as a conventional liquid material vaporizer. In the main body block there are formed a liquid material intake path through which a liquid material is introduced, a carrier gas intake path through which a carrier gas is introduced, and a gas discharge path through which a gas-liquid mixture formed by the liquid material and the carrier gas is discharged.

Moreover, in this liquid material vaporizer, an annular recessed portion is formed in an upper surface of the main body bock (i.e., in a valve seat surface which the control valve is either in contact with or is separated from), and a downstream-side aperture of the liquid material intake path is formed in a bottom surface of this annular recessed portion. In addition, a narrow, elongated groove, in which a downstream side aperture of the carrier gas intake path and holes leading to a gas discharge path of the gas-liquid mixture are formed, is formed extending rectilinearly on an inner side of the annular recessed portion.

However, because the mixing portion where the liquid material and the carrier gas are mixed together is a narrow, elongated groove extending rectilinearly, and because this mixing portion is spatially limited, there is a considerable pressure loss in this mixing portion. As a result, the problem arises that it is difficult for a gas-liquid mixture to be supplied at a satisfactory flow rate.

### [Prior Art Document]

### [Patent Document]

Patent Document 1: JP Patent No. 4393677

### SUMMARY OF THE INVENTION

The present invention was, therefore, conceived in order to solve the above-described problem, and it is an object thereof to reduce pressure loss in a gas-liquid mixer.

In other words, a liquid material vaporizer according to the present invention is a gas-liquid mixer that mixes together a liquid material and a carrier gas so as to create a gas-liquid mixture, and that includes a main body block that is used to mix together the liquid material and the carrier gas, and a control valve that is disposed in the main body block and adjusts a flow rate of the liquid material, wherein an annular liquid material supply groove having a supply port for the liquid material formed in an inner surface thereof, and an annular gas-liquid mixing groove having a supply port for the carrier gas and a discharge port for the gas-liquid mixture formed in an inner surface thereof are formed in a valve seat portion of the main body block which the control valve is either in contact with or is separated from, and one of either the liquid material supply groove or the gas-liquid mixing groove is formed on an inner side of the other of the liquid material supply groove or the gas-liquid mixing groove.

According to this liquid material vaporizer, because one of either the annular liquid material supply groove or the annular gas-liquid mixing groove is formed on an inner side of the other of the liquid material supply groove or the gas-liquid mixing groove, the liquid material and the carrier gas can be mixed together over a broader surface area than has hitherto been possible, and it is possible to reduce pressure loss in the mixing portion. As a result, it is possible for a gas-liquid mixture to be supplied at a satisfactory flow rate.

It is also desirable that the liquid material supply groove and the gas-liquid mixing groove each be formed having a circular ring shape.

If this type of structure is employed, then because each groove is formed having a circular ring shape, it is possible to reduce pressure loss while simultaneously reducing any retention in the respective grooves.

In order for a gas-liquid mixture to be supplied at a satisfactory flow rate, it is desirable that there be formed a plurality of at least one of the liquid material supply grooves and the gas-liquid mixing grooves.

It is also desirable that a plurality of the liquid material supply grooves and the gas-liquid mixing grooves be formed alternatingly with each other.

If this type of structure is employed, then it becomes possible for a liquid material to flow easily from the liquid material supply grooves to the gas-liquid mixing grooves.

It is also desirable that the carrier gas supply port and the gas-liquid mixture discharge port be formed on two sides sandwiching a center of the gas-liquid mixing groove.

If this type of structure is employed, then it is possible to lengthen the flow path used by the carrier gas in the gas-liquid mixing grooves, and the liquid material and the carrier gas can be mixed together easily in the gas-liquid mixing grooves.

In the liquid material supply grooves, it is desirable that the liquid material supply port be formed on a line that extends orthogonally relative to a line that connects together the carrier gas supply port and the gas-liquid mixture discharge port.

If this type of structure is employed, then it becomes possible to easily form a liquid material flow path, a carrier gas flow path, and a gas-liquid mixture flow path that are to be formed within the main body block. Moreover, it is also possible for a liquid material to be introduced efficiently between the carrier gas supply port and the gas-liquid mixture discharge port in the gas-liquid mixing grooves.

Moreover, a liquid material vaporizer according to the present invention is characterized in being provided with the above-described gas-liquid mixer, and with a vaporizer that heats the gas-liquid mixture so as to vaporize the liquid material.

In this way, according to the present invention, it is possible to reduce pressure loss in a gas-liquid mixer.

### BRIEF DESCRIPTION OF THE DRAWINGS

FIG. 1 is a view schematically showing the structure of a liquid material vaporizer according to an embodiment of the present invention;
FIG. 2 is a top view of a main body block of a gas-liquid mixer of the same embodiment;
FIG. 3 is a perspective view of the main body block of the gas-liquid mixer of the same embodiment;
FIG. 4 is a top view of a main body block of a gas-liquid mixer of a variant embodiment;
FIG. 5 is a perspective view of the main body block of the gas-liquid mixer of a variant embodiment; and
FIG. 6 is a top view of a main body block of a gas-liquid mixer of a variant embodiment.

### DETAILED DESCRIPTION

Hereinafter, an embodiment of a liquid material vaporizer according to the present invention will be described with reference to the drawings. Note that, in order to simplify an understanding thereof, each of the drawings depicted below is shown schematically with omissions or enhancements made where these have been deemed appropriate. In addition, component elements that are the same in the respective drawings are indicated by the same descriptive symbols and any duplicated description thereof is omitted.

### [Basic Structure of a Liquid Material Vaporizer 100]

A liquid material vaporizer 100 according to the present embodiment is incorporated, for example, into a semiconductor manufacturing line or the like, and is used to supply gas at a predetermined flow rate to a chamber or the like that is used in a semiconductor manufacturing process.

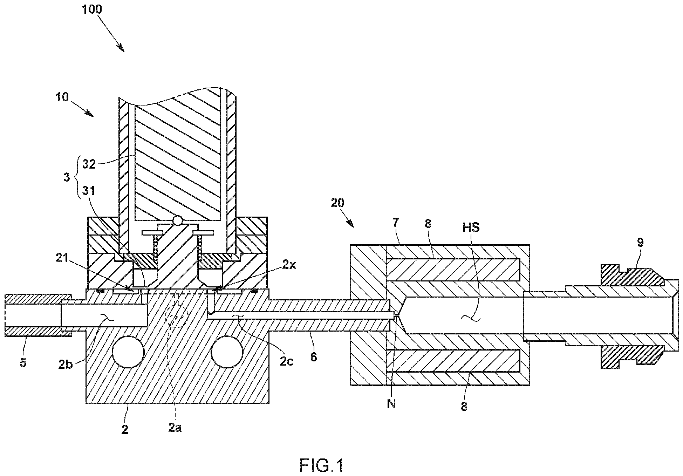

More specifically, as is shown in FIG. 1, the liquid material vaporizer 100 is equipped with gas-liquid mixer 10 that mixes together a liquid material and a carrier gas so as to create a gas-liquid mixture, and a vaporizer 20 into which the gas-liquid mixture is introduced and that then vaporizes the liquid material contained in that gas-liquid mixture.

### [Gas-Liquid Mixer 10]

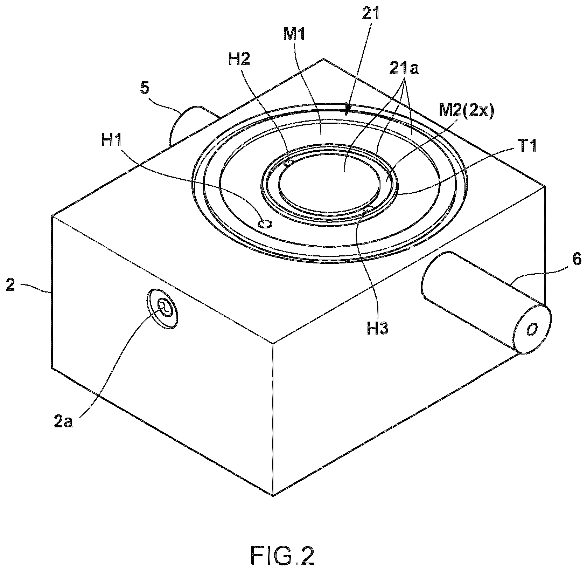

As is shown in FIG. 2, the gas-liquid mixer 10 is provided with a main body block 2 that includes a mixing portion 2x that mixes together the liquid material and the carrier gas, and with a control valve 3 that is provided in the main body block 2 and adjusts the flow rate of the liquid material.

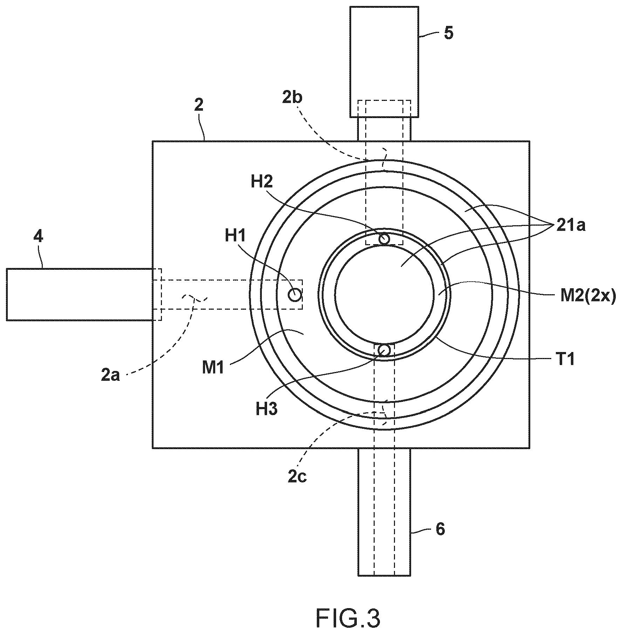

As is shown in FIG. 2 and FIG. 3, the main body block 2 is formed so as to include a liquid material flow path 2a through which a liquid material flows, a carrier gas flow path 2b through which a carrier gas flows, and a gas-liquid mixture flow path 2c through which a gas-liquid mixture flows. Each of these flow paths 2a, 2b, and 2c opens onto a valve seat portion 21 that is formed on an upper surface of the main body block 2 and which is a portion that the control valve 3 either comes into contact with or separates from. In this valve seat portion 21 of the main body block 2, a merging portion where the carrier gas flow path 2b and the gas-liquid mixing flow path 2c merge together forms the mixing portion 2x where the liquid material and the carrier gas are mixed together. Note that the structure of the valve seat portion 21 of the main body block 2 is described in detail below.

The control valve 3 functions as a flow rate control valve and, as is shown in FIG. 1, is disposed via a sealing component (not shown in the drawings) on the upper surface of the main body block 2. The control valve 3 is provided with a diaphragm 31 which serves as a valve body portion that either comes into contact with or separates from the valve seat portion 21 of the valve body block 2, and with an actuator 32 that presses against the diaphragm 31 so as to cause it to deform. Note that the actuator 32 may be formed using, for example, a piezo stack.

Moreover, as is shown in FIG. 2 and FIG. 3 and the like, a liquid material supply pipe 4 that is used to supply a liquid material to the liquid material flow path 2a, a carrier gas supply pipe 5 that is used to supply a carrier gas to the carrier gas flow path 2b, and a gas-liquid mixture discharge pipe 6 that is used to discharge a gas-liquid mixture from the gas-liquid mixture flow path 2c are each connected to the main body block 2.

A mass flow meter (not shown in the drawings) that measures a flow rate of the liquid material flowing through the liquid material supply pipe 4 is provided on the upstream side of the liquid material supply pipe 4. The control valve 3 performs feedback control based on measurement values obtained by this flow rate meter such that the liquid material being supplied to the mixing portion 2x is maintained at a predetermined flow rate. In addition, a mass flow controller that adjusts the flow rate of the carrier gas flowing through the carrier gas supply pipe 5 is provided on the upstream side of the carrier gas supply pipe 5.

### [Vaporizer 20]

As is shown in FIG. 1, the vaporizer 20 is provided with a heating block 7 that has a heating flow path HS which heats the gas-liquid mixture produced by the gas-liquid mixer 10. In addition, the vaporizer 20 is structured so as to be able to accelerate the vaporization of the liquid material by spraying the gas-liquid mixture into the heating flow path HS through a nozzle portion N.

A heater 8 that is used to heat the gas-liquid mixture flowing through the heating flow path HS is built into the heating block 7. This heating block 7 is formed from a thermally conductive metal (for example, aluminum). An upstream-side end portion of the heating flow path HS is connected to the gas-liquid mixture discharge pipe 6. Moreover, a discharge port 9 that discharges a vaporized gas generated when the liquid material is vaporized is connected to a downstream-side end portion of the heating flow path HS.

### [Basic Structure of the Gas-Liquid Mixer 10 (Detailed Structure of the Valve Seat Portion 21)]

Next, the structure of the valve seat portion 21 of the gas-liquid mixer 10 of the present embodiment will be described in detail.

An annular liquid material supply groove M1 having a supply port H1 for the liquid material formed in an inner surface (in this case, in a bottom surface) thereof, and an annular gas-liquid mixing groove M2 which forms the mixing portion 2x and has a supply port H2 for the carrier gas and a discharge port H3 for the gas-liquid mixture formed in an inner surface (in this case, in a bottom surface) thereof are formed in the valve seat portion 21 of the present embodiment. Note that a structure in which the supply port H1 is formed in a side surface of the liquid material supply groove M1 may also be employed, and a structure in which the discharge port H3 is formed in a side surface of the gas-liquid mixing groove M2 may also be employed.

In the liquid material supply groove M1 of the present embodiment, only one liquid material supply port H1 is formed, and this liquid material supply port H1 communicates with the liquid material flow path 2a. In addition, only one carrier gas supply port H2 is formed in the gas-liquid mixing groove M2, and the carrier gas flow path 2b communicates with this supply port H2. Furthermore, only one gas-liquid mixture discharge port H3 is formed in the gas-liquid mixing groove M2, and the gas-liquid mixture flow path 2c communicates with this discharge port H3. Note that it is also possible for two or more supply ports H1 to be formed in the liquid material supply groove M1, and for two or more carrier gas supply ports H2 to be formed in the gas-liquid mixing groove M2, and also for two or more discharge ports H3 to be formed in the gas-liquid mixing groove M2.

When the liquid material supply groove M1 and the gas-liquid mixing groove M2 are looked at in plan view, one of the liquid material supply groove M1 and the gas-liquid mixing groove M2 is formed on the inner side of the other of the liquid material supply groove M1 and the gas-liquid mixing groove M2. More specifically, when looked at in plan view, the liquid material supply groove M1 and the gas-liquid mixing groove M2 are formed concentrically on the valve seat portion 21. Note that, in this case, the term 'concentrically' refers not only to a structure in which the centers of both the liquid material supply groove M1 and the gas-liquid mixing groove M2 perfectly coincide with each other, but also to structures in which they are slightly offset from each other. In addition, when looked at in plan view, the liquid material supply groove M1 and the gas-liquid mixing groove M2 are each formed having a circular ring shape and, in the present embodiment, are formed as concentric circles with the liquid material supply groove M1 located on the outer side and the gas-liquid mixing groove M2 located on the inner side.

In the present embodiment, the carrier gas supply port H2 and the gas-liquid mixture discharge port H3 are formed in the gas-liquid mixing groove M2 on mutually opposite sides sandwiching the center thereof. As a result, the carrier gas that is supplied from the carrier gas supply port H2 is divided into two streams from the supply port H2 and these streams both flow to the gas-liquid mixture discharge port H3. In addition, in the liquid material supply groove M1, the liquid material supply port H1 is formed on a line that extends orthogonally relative to a line that connects together the carrier gas supply port H2 and the gas-liquid mixture discharge port H3. By employing this structure, in the main body block 2 it becomes possible for the carrier gas flow path 2b and the gas-liquid mixture flow path 2c to be formed on the same straight line, and the liquid material flow path 2a can be formed so as to extend orthogonally relative to these flow paths 2b and 2c. As a result, the respective flow paths 2a through 2c can be formed easily in the main body block 2.

In the above-described structure of the valve seat portion 21, an upper surface of a partition wall portion T1 that is formed between the liquid material supply groove M1 and the gas-liquid mixing groove M2 forms part of a valve seat surface 21a, and an upper surface of a central portion formed on the inner side of the gas-liquid mixing groove M2 also forms part of this valve seat surface 21a.

In a state in which the control valve 3 is in contact with the valve seat surface 21a (i.e., when the valve is in a closed state), both the liquid material supply groove M1 and the gas-liquid mixing groove M2 are blocked so that the supply of liquid material to the gas-liquid mixing groove M2 is halted. In this state, carrier gas is supplied from the carrier gas supply port H2 to the gas-liquid mixing groove M2, and this carrier gas flows out through the discharge port H3.

In contrast, in a state in which the control valve 3 is separated from the valve seat surface 21a (i.e., when the valve is in an open state), the liquid material supply groove M1 and the gas-liquid mixing groove M2 are in communication with each other so that liquid material is being supplied to the gas-liquid mixing groove M2. By adjusting the valve opening of the control valve 3 (i.e., the distance thereof from the valve seat surface 21a), the flow rate of the liquid material flowing to the gas-liquid mixing groove M2 is adjusted. More specifically, in addition to liquid material being supplied from the liquid material supply port H1 to the liquid material supply groove M1, in an overall circumferential direction, the liquid material also flows from the liquid material supply groove M1 to the gas-liquid mixing groove M2. At this time, the liquid material is mixed with carrier gas above the partition wall portion T1, or is mixed with the carrier gas in the gas-liquid mixing groove M2. The resulting gas-liquid mixture then flows out via the discharge port H3.

### [Effects Obtained from the Present Embodiment]

In this way, according to the liquid material vaporization device 100 of the present embodiment, because one of either the annular liquid material supply groove M1 or the annular gas-liquid mixing groove M2 is formed on an inner side of the other of the liquid material supply groove M1 or the gas-liquid mixing groove M2, the liquid material and the carrier gas can be mixed together over a broader surface area than has been possible using a conventional structure, and it is possible to reduce pressure loss in the mixing portion 2x. As a result, it is possible for a gas-liquid mixture to be supplied at a high flow rate.

### [Additional Embodiments]

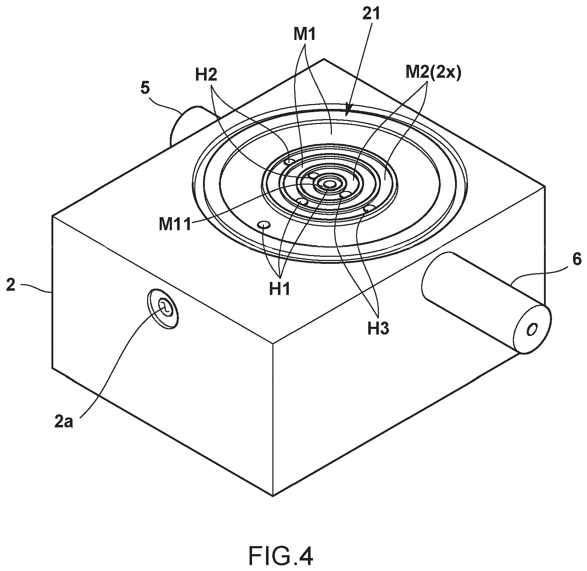

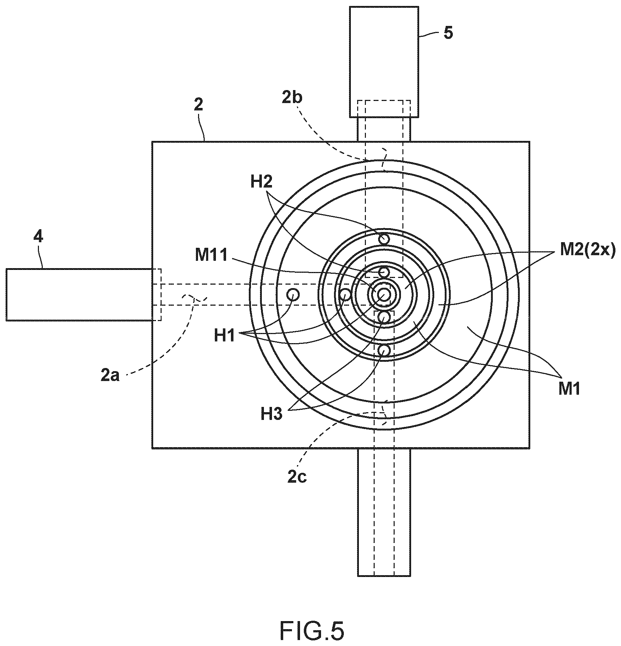

As is shown in FIG. 4 and FIG. 5, it is also possible, for example, for a plurality of at least one of liquid material supply grooves M1 or gas-liquid mixing grooves M2 to be formed. An example in which two annular liquid material supply grooves M1 and two annular gas-liquid mixing grooves M2 are formed is shown in FIG. 4 and FIG. 5. Here, an example is shown in which circular-ring shaped liquid material supply grooves M1 and circular-ring shaped gas-liquid mixing grooves M2 are formed concentrically, for example, in this sequence from the outer side. In addition, a circular liquid material supply groove M11 is formed on the inner side of the innermost gas-liquid mixing groove M2. In this valve seat portion 21 structure, the valve seat surface is formed by upper surfaces of partition wall portions formed between the liquid material supply grooves M1 and M11 and the gas-liquid mixing grooves M2.

The liquid material supply ports H1 formed in the bottom surfaces of the respective liquid material supply grooves M1 and M11 communicate with the liquid material flow path 2a. Moreover, the carrier gas supply ports H2 formed in the bottom surfaces of the respective gas-liquid mixing grooves M2 communicate with the carrier gas flow path 2b. In addition, the gas-liquid mixture discharge ports H3 formed in the bottom surfaces of the respective gas-liquid mixing grooves M2 communicate with the gas-liquid mixture flow path 2c.

In a state in which the control valve 3 is in contact with the valve seat surface (i.e., when the valve is in a closed state), both the plurality of liquid material supply grooves M1 and M11 and the plurality of gas-liquid mixing grooves M2 are blocked so that the supply of liquid material to the gas-liquid mixing grooves M2 is halted. In this state, carrier gas is supplied from the carrier gas supply ports H2 to the plurality of gas-liquid mixing grooves M2, and this carrier gas flows out through the discharge ports H3.

In contrast, in a state in which the control valve 3 is separated from the valve seat surface (i.e., when the valve is in an open state), the plurality of liquid material supply grooves M1 and M11 and the plurality of gas-liquid mixing grooves M2 are in communication with each other so that liquid material is being supplied to the plurality of gas-liquid mixing grooves M2. More specifically, in addition to liquid material being supplied from the liquid material supply ports H1 to the plurality of liquid material supply grooves M1 and M11, in an overall circumferential direction, the liquid material also flows from the plurality of liquid material supply grooves M1 and M11 to the plurality of gas-liquid mixing grooves M2. At this time, the liquid material is mixed with carrier gas in the partition wall portion, or is mixed with the carrier gas in the gas-liquid mixing grooves M2. The resulting gas-liquid mixture then flows out via the discharge ports H3.

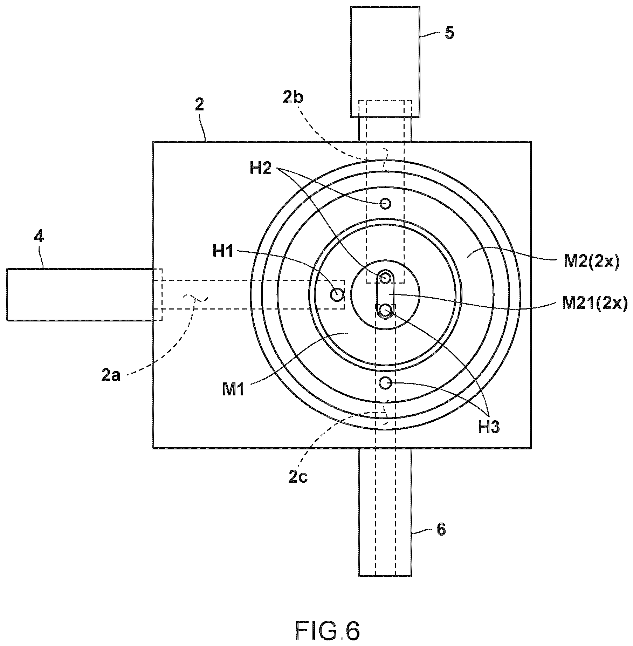

Furthermore, as is shown in FIG. 6, it is also possible for an annular gas-liquid mixing groove M2 to be formed on the outer side and an annular liquid material supply groove M1 to be formed on the inner side and, in addition to this, for a rectilinear gas-liquid mixing groove M21 in which a carrier gas supply hole H2 and a gas-liquid mixture discharge hole H3 are formed to be formed on the inner side of this annular liquid material supply groove M1.

It is also possible for the placements of the liquid material supply grooves M1 and the gas-liquid mixing grooves M2 relative to each other to be the opposite of those described in the foregoing embodiments and the like.

In addition, the shape of one of either the liquid material supply grooves M1 or the gas-liquid mixing grooves M2 is not limited to being a circular ring shape when looked at in plan view, and it is also possible for one of either the liquid material supply grooves M1 or the gas-liquid mixing grooves M2 to be formed in a different shape such as an elliptical shape, an elongated circle shape, or a rectangular shape or the like when looked at in plan view. It is also possible for one of either the liquid material supply grooves M1 or the gas-liquid mixing grooves M2 to not be formed continuously around the entire circumference thereof, but to instead be formed, for example, having a portion of the annular circumference thereof cut out such as in a C-shape or the like. In other words, in the present invention, an annular shape having a portion of the annular circumference thereof cut out is included in the concept of an annular shape. For example, in a case in which the gas-liquid mixing grooves M2 are formed having a portion of the annular circumference thereof cut out in a C-shape or the like, then the carrier gas supply ports H2 may be formed in one end portion in the circumferential direction of the gas-liquid mixing grooves M2, and the gas-liquid mixture discharge ports H3 may be formed in the other end portion in the circumferential direction of the gas-liquid mixing grooves M2. In addition, it is also possible for one of either the supply ports H2 or the discharge ports H3 to be formed in a central portion in the circumferential direction of the gas-liquid mixing grooves M2, and for the other of the supply ports H2 or the discharge ports H3 to be formed in both end portions in the circumferential direction of the gas-liquid mixing grooves M2.

Furthermore, it should be understood that the present invention is not limited to the above-described embodiments, and that various modifications and the like may be made thereto insofar as they do not depart from the scope of the present invention as defined by the appended claims.

### Reference Characters List

- 100: Liquid Material Vaporization Device
- 10: Gas-Liquid Mixer
- 20: Vaporizer
- 2: Main Body Block
- 3: Control Valve
- 21: Valve Seat Portion
- M1: Liquid Material Supply Groove
- H1: Liquid Material Supply Port
- M2: Gas-Liquid Mixing Groove (Mixing Portion)
- H2: Carrier Gas Supply Port
- H3: Gas-Liquid Mixture Discharge Port

## Claims

1. A gas-liquid mixer that mixes together a liquid material and a carrier gas so as to create a gas-liquid mixture, comprising:
a main body block (2) that is used to mix together the liquid material and the carrier gas; and
a control valve (3) that is disposed in the main body block and adjusts a flow rate of the liquid material; wherein
an annular liquid material supply groove (M1) having a supply port (H1) for the liquid material formed in an inner surface thereof, and an annular gas-liquid mixing groove (M2) having a supply port (H2) for the carrier gas and a discharge port (H3) for the gas-liquid mixture formed in an inner surface thereof are formed in a valve seat portion (21) of the main body block which the control valve is either in contact with or is separated from, and
one of either the liquid material supply groove or the gas-liquid mixing groove is formed on an inner side of the other of the liquid material supply groove or the gas-liquid mixing groove.

2. The gas-liquid mixer according to claim 1, wherein the liquid material supply groove and the gas-liquid mixing groove are each formed having a circular ring shape.

3. The gas-liquid mixer according to claims 1 or 2, wherein there are formed a plurality of at least one of the liquid material supply grooves and the gas-liquid mixing grooves.

4. The gas-liquid mixer according to any one of claims 1 through 3, wherein a plurality of the liquid material supply grooves and the gas-liquid mixing grooves are formed alternatingly with each other.

5. The gas-liquid mixer according to any one of claims 1 through 4, wherein the carrier gas supply port and the gas-liquid mixture discharge port are formed on both sides sandwiching a center of the gas-liquid mixing groove.

6. The gas-liquid mixer according to claim 5, wherein the liquid material supply port is formed on a line that extends orthogonally relative to a line that connects together the carrier gas supply port and the gas-liquid mixture discharge port.

7. A liquid material vaporizer comprising:
the gas-liquid mixer according to any one of claims 1 through 6; and
a vaporizer that heats the gas-liquid mixture so as to vaporize the liquid material.

## Patentansprüche

1. Gas-Flüssigkeits-Mischer, der ein flüssiges Material und ein Trägergas vermischt, um ein Gas-Flüssigkeits-Gemisch zu erzeugen, umfassend:
einen Hauptkörperblock (2), der zum Vermischen des flüssigen Materials und des Trägergases verwendet wird; und
ein Steuer- bzw. Regelventil (3), das in dem Hauptkörperblock angeordnet ist und eine Strömungs- bzw. Flussrate des flüssigen Materials einstellt; wobei
eine ringförmige Flüssiges-Material-Zufuhrnut (M1), die eine Zufuhröffnung (H1) für das flüssige Material in einer Innenfläche bzw. -oberfläche davon gebildet aufweist, und eine ringförmige Gas-Flüssigkeits-Mischnut (M2), die eine Zufuhröffnung (H2) für das Trägergas und eine Auslassöffnung (H3) für das Gas-Flüssigkeits-Gemisch in einer Innenfläche bzw. -oberfläche davon gebildet aufweist, in einem Ventilsitzabschnitt (21) des Hauptkörperblocks ausgebildet sind, mit dem das Steuer- bzw. Regelventil entweder in Kontakt ist oder von dem es getrennt ist, und
eine der Flüssiges-Material-Zufuhrnut oder der Gas-Flüssigkeits-Mischnut an einer Innenseite der anderen der Flüssiges-Material-Zufuhrnut oder der Gas-Flüssigkeits-Mischnut ausgebildet ist.

2. Gas-Flüssigkeits-Mischer nach Anspruch 1, wobei die Flüssiges-Material-Zufuhrnut und die Gas-Flüssigkeits-Mischnut jeweils in einer Kreisringform ausgebildet sind.

3. Gas-Flüssigkeits-Mischer nach Anspruch 1 oder 2, wobei eine Mehrzahl von zumindest einer der Flüssiges-Material-Zufuhrnuten und der Gas-Flüssigkeits-Mischnuten ausgebildet sind.

4. Gas-Flüssigkeits-Mischer nach einem der Ansprüche 1 bis 3, wobei eine Mehrzahl der Flüssiges-Material-Zufuhrnuten und der Gas-Flüssigkeits-Mischnuten miteinander abwechselnd ausgebildet sind.

5. Gas-Flüssigkeits-Mischer nach einem der Ansprüche 1 bis 4, wobei die Trägergas-Zufuhröffnung und die Gas-Flüssigkeits-Gemisch-Auslassöffnung auf beiden Seiten ausgebildet sind und eine Mitte der Gas-Flüssigkeits-Mischnut sandwichartig umgeben.

6. Gas-Flüssigkeits-Mischer nach Anspruch 5, wobei die Flüssiges-Material-Zufuhröffnung auf einer Linie ausgebildet ist, die sich orthogonal relativ zu einer Linie erstreckt, welche die Trägergas-Zufuhröffnung und die Gas-Flüssigkeits-Gemisch-Auslassöffnung miteinander verbindet.

7. Flüssiges-Material-Verdampfer, umfassend:
den Gas-Flüssigkeits-Mischer nach einem der Ansprüche 1 bis 6; und
einen Verdampfer, der das Gas-Flüssigkeits-Gemisch erhitzt, um das flüssige Material zu verdampfen.

## Revendications

1. Mélangeur de gaz-liquide qui mélange ensemble un matériau liquide et un gaz porteur de manière à créer un mélange de gaz-liquide, comprenant :
un bloc de corps principal (2) qui est utilisé pour mélanger ensemble le matériau liquide et le gaz porteur ; et
une soupape de commande (3) qui est disposée dans le bloc de corps principal et ajuste un débit du matériau liquide ; dans lequel
une rainure annulaire d'alimentation en matériau liquide (M1) ayant un port d'alimentation (H1) pour le matériau liquide formé dans une surface interne de celle-ci, et une rainure annulaire de mélange de gaz-liquide (M2) ayant un port d'alimentation (H2) pour le gaz porteur et un port d'évacuation (H3) pour le mélange de gaz-liquide formés dans une surface interne de celle-ci sont formées dans une portion de siège de soupape (21) du bloc de corps principal avec laquelle la soupape de commande est en contact ou de laquelle elle est séparée, et
une de l'une ou l'autre de la rainure d'alimentation en matériau liquide ou la rainure de mélange de gaz-liquide est formée sur un côté interne de l'autre de la rainure d'alimentation en matériau liquide ou la rainure de mélange de gaz-liquide.

2. Mélangeur de gaz-liquide selon la revendication 1, dans lequel la rainure d'alimentation en matériau liquide et la rainure de mélange de gaz-liquide sont chacune formées en ayant une forme d'anneau circulaire.

3. Mélangeur de gaz-liquide selon la revendication 1 ou 2, dans lequel une pluralité d'au moins une des rainures d'alimentation en matériau liquide et des rainures de mélange de gaz-liquide sont formées.

4. Mélangeur de gaz-liquide selon l'une quelconque des revendications 1 à 3, dans lequel une pluralité des rainures d'alimentation en matériau liquide et des rainures de mélange de gaz-liquide sont formées en alternance l'une avec l'autre.

5. Mélangeur de gaz-liquide selon l'une quelconque des revendications 1 à 4, dans lequel le port d'alimentation en gaz porteur et le port d'évacuation de mélange de gaz-liquide sont formés sur les deux côtés prenant en sandwich un centre de la rainure de mélange de gaz-liquide.

6. Mélangeur de gaz-liquide selon la revendication 5, dans lequel le port d'alimentation en matériau liquide est formé sur une ligne qui s'étend orthogonalement par rapport à une ligne qui connecte ensemble le port d'alimentation en gaz porteur et le port d'évacuation de mélange de gaz-liquide.

7. Vaporisateur de matériau liquide comprenant :
le mélangeur de gaz-liquide selon l'une quelconque des revendications 1 à 6 ; et
un vaporisateur qui chauffe le mélange de gaz-liquide de manière à vaporiser le matériau liquide.
